# EUROPEAN PATENT APPLICATION

(11) **EP 1 959 350 A2**
(43) Date of publication of application: **20.08.2008**
(21) Application number: 08250423.4
(22) Date of filing: 05.02.2008
(51) Int. Cl.: G06F 15/76

(54) **Fusion memory device and method**

(30) Priority: 05.02.2007 KR 20070011618
(71) Applicant: Samsung Electronics Co., Ltd., Suwon-si, Gyeonggi-do (KR)
(72) Inventor: Oh, Sung Jo c/o Samsung Electronics Co., Ltd., Gyeonggi-do (KR)
(74) Representative: Boakes, Jason Carrington

(57) **Abstract**

A fusion memory device and method that are capable of encoding data to be written and decoding the data to be read is provided. The fusion memory device includes a main memory for storing multimedia data, an auxiliary memory for buffering the multimedia data in a writing and a reading modes, and a memory controller which controls buffering the multimedia data in the auxiliary, encoding the buffered multimedia data, and writing the encoded in the main memory in the write mode, and controls decoding the multimedia data output from the main memory, buffering the decoded multimedia data, and outputting the buffered multimedia data to a host device in the read mode.

## Description

### BACKGROUND OF THE INVENTION

### 1. Field of the Invention

The present invention relates to a fusion memory and, in particular, to a fusion memory device and method that are capable of encoding multimedia data to be written and decoding multimedia data to be read.

### 2. Description of the Related Art

A fusion memory is a device which integrates different types of memories and logics on a single chip. The fusion memory is advantageous in that system specific software can be provided with system memory. With the combination of the high density memory and logic together with software availability, the fusion memory is expected to lead the mobile device market facing new demands in the digital convergence age.

Recently, mobile devices such as cellular phones integrate various functional components such as digital broadcast receiver, camera, MP3, Bluetooth^{®} ("Bluetooth") modules. Such a functional convergence of the mobile device requires cooperative operations between the components and application programs. A mobile device is also provided with a coding/decoding function for processing multimedia data.

In the conventional mobile devices, however, most of multimedia data is processed under the control of a central controller, whereby processing load is concentrated at the central controller of the mobile device. Also, the conventional mobile device has a drawback in that the buffer memory, which is required for encoding and decoding the multimedia data, is assigned in an external memory (e.g., external random access memory), resulting in a waste of resources. For example, in the case of a mobile device equipped with a 2 megapixel-camera module, a 4-Mbyte buffer size (2 megapixels * 2) is required for processing the camera data.

### SUMMARY OF THE INVENTION

The present invention has been made in an effort to solve at least the above problems. The present invention provides a fusion memory device and method that is capable of storing multimedia data in a compressed format.

The present invention provides a fusion memory device and method that is capable of reading compressed multimedia data in a decompressed format.

The present invention provides a fusion memory device, which is provided with a main memory, an auxiliary memory, and a memory controller, and an operating method of the fusion memory device that are capable of storing multimedia data in a compressed format and reading the multimedia data in a decompressed format.

In accordance with an aspect of the present invention, a fusion memory device includes a main memory for storing multimedia data; an auxiliary memory for buffering the multimedia data in write and read modes; and a memory controller which controls buffering the multimedia data in the auxiliary, encoding the buffered multimedia data, and writing the encoded in the main memory in the write mode, and controls decoding the multimedia data output from the main memory, buffering the decoded multimedia data, and outputting the buffered multimedia data to a host device.

In accordance with another aspect of the present invention a data access method for a fusion memory device having a main memory, auxiliary memory, and at least one pair of a coder and a decoder, includes analyzing multimedia data input by a host device in a write mode, activating a coder on the basis of an analysis result, encoding the multimedia data using the coder, and storing the coded multimedia data in the main memory; and activating a decoder in a read mode, decoding the multimedia data using the decoder, and outputting the decoded multimedia data to the host device.

### BRIEF DESCRIPTION OF THE DRAWINGS

The above and other objects, features and advantages of the present invention will be more apparent from the following detailed description in conjunction with the accompanying drawings, in which:
FIG. 1 is a block diagram illustrating a fusion memory device according to an exemplary embodiment of the present invention;
FIG. 2 is a block diagram illustrating a cooperation of a fusion memory device and a host device according to an exemplary embodiment of the present invention;
FIG. 3 is a block diagram illustrating read/write operations of a fusion memory device according to an exemplary embodiment of the present invention;
FIG. 4 is a block diagram illustrating a configuration of a fusion memory device according to an exemplary embodiment of the present invention;
FIG. 5 is a block diagram illustrating an interoperation between the fusion memory device of FIG. 4 and a host device according to an exemplary embodiment of the present invention;
FIG. 6 is a block diagram illustrating how to encode and store multimedia data in the fusion memory device of FIG. 4; and
FIG. 7 is a block diagram illustrating how to decode and output multimedia data in the fusion memory device of FIG. 4.

### DETAILED DESCRIPTION OF EXEMPLARY EMBODIMENTS

Exemplary embodiments of the present invention are described with reference to the accompanying drawings in detail. The same reference numbers are used throughout the drawings to refer to the same or like parts. Detailed descriptions of well-known functions and structures incorporated herein may be omitted to avoid obscuring the subject matter of the present invention.

In the following, types of memory and units of data processing and compression/decompression are provided to enable a clear and consistent understanding of the detailed description and the claims. While the invention is shown and described with reference to certain exemplary embodiments thereof, it will be understood by those skilled in the art that various changes in form and details may be made therein without departing from the spirit and scope of the invention as defined by the appended claims.

In the following exemplary embodiments, the term "fusion memory" means a memory device integrated with various types of memory and non-memory together with specific logics on a single chip in addition to a main memory. The fusion memory may be a memory for storing multimedia data. The term "multimedia data" is used to indicate arbitrary data for example, but not limited to, image, audio, video, and other types of data files. A memory controller has a coding/decoding function and controls reading and writing the multimedia data out of and into the main memory. The terms "coding and decoding" are used equivalently with "compressing and decompressing".

The present invention may be a multimedia data-dedicated fusion memory having a logic for encoding multimedia data and writing the encoded multimedia data within the main memory and for decoding the coded multimedia data and reading the decoded multimedia data from the main memory. The fusion memory having the logic enables storing and loading large amount of multimedia in a limited memory space.

In the fusion memory device of the present invention, the coding and decoding processes on the multimedia data are performed by the fusion memory device itself, resulting in a reduction of the processing load of the system controller. The fusion memory device of the present invention is provided with a coder and a decoder interoperating with the main controller for encoding and decoding multimedia data such that the processing load of the system controller is distributed. The buffer memory required for coding and decoding the multimedia data is assigned in the internal memory (e.g., Static Random Access Memory (SRAM)) rather than in an external memory.

The multimedia data can include, but is not limited to, video, audio, and text data. In more detail, the multimedia can include Motion Picture Experts Group (MPEG), Joint Photographic Experts Group (JPEG), Portable Network Graphics (PNG), and MPEG Audio Layer 3 (MP3), H.264, Windows Media Video (WMV), Windows Media Audio (WMA), Digital Video Broadcasting (DVB), Digital Multimedia Broadcasting (DMB), and MediaFLO files. The multimedia data input to the fusion memory device can be stored in a compressed format or an uncompressed format. For example, the MP3 file should be decoded to be played, an image captured by a camera module may be coded to be stored and decoded to be played in a specific image format.

In the following embodiment, the fusion memory device is provided with codecs for encoding and decoding the various multimedia data such that the processing load of the system memory of a host device is distributed. By assigning the buffer memory required for coding and decoding the multimedia data in the fusion memory device, the external memory utilization of the host device can be improved.

The fusion memory device of the present invention includes a main memory which stores the multimedia data, an auxiliary memory which buffers the multimedia in use, a coder and a decoder, and a memory controller which controls buffering the multimedia data within the auxiliary data during the coding process and writing the coded multimedia data within the main memory in the write mode and controls decoding the compressed multimedia read from the main memory and outputting the decoded multimedia data to the host device in read mode.

The memory controller is provided with at least one coder for coding the multimedia data, at least one decoder for decoding the compressed multimedia data, an information detector for analyzing the multimedia data and extracting codec information for selecting the coder and decoder to be used and file address information, a file system controller for generating file system assignment information for accessing the multimedia data on the basis of the file address information, and a core controller for storing the coded multimedia data within the main memory with reference to the information output by the information detector and the file system controller in the write mode and decoding the compressed multimedia data to be output from the main memory in the read mode.

The core controller activates the coder with reference to the codec information and controls the operation of the main memory in the write mode such that the multimedia data coded by the coder is stored at a predetermined location of the main memory assigned by the file system controller. The core controller also activates the decoder with reference to the codec information and controls the operation of the main memory in the read mode such that the multimedia is read from a specific location of the main memory assigned by the file system controller. The core controller controls the auxiliary memory to buffer the multimedia data input from outside and coded by the coder in the write mode such that the coded multimedia data is stored within the main memory. The core controller also controls the auxiliary memory to buffer the multimedia data read from the main memory and decoded by the decoder such that the decoded multimedia data are output to the host device.

The coder and decoder are built into the fusion memory device in the form of hardware components. The coder and decoder includes at least one of a pair of video coder and decoder and pair of audio coder and decoder.

As described above, the fusion memory device of the present invention may include a main memory, an auxiliary memory, and at least one coder and decoder pair. A method for operating the above structured fusion memory includes a writing procedure which includes analyzing a coding scheme of multimedia data input in the write mode and activating a coder according to the coding scheme such that the data stream is coded by the coder and stored in the main memory, and a read procedure which includes activating a decoder according to the coding scheme of the coded multimedia data read from the main memory in the writing mode and decoding the coded multimedia data using the decoder such that the decoded multimedia data is output to the host device.

The write procedure includes buffering the input multimedia data in the auxiliary memory, coding the buffered multimedia data, and storing the coded multimedia data within the main memory. Storing the coded multimedia data within the main memory includes analyzing location information of the multimedia data assigned by a file system and configuring storage location of the multimedia data in the main memory.

The read procedure includes reading the coded multimedia data from the main memory, decoding the read multimedia data, buffering the decoded multimedia data within the auxiliary memory, and outputting the decoded multimedia data to the host device.

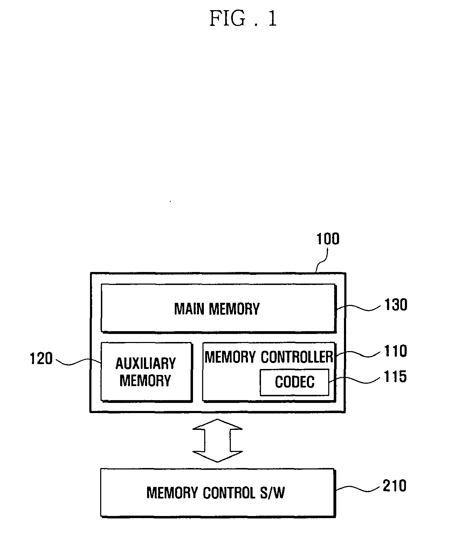

FIG. 1 is a block diagram illustrating a fusion memory device according to an exemplary embodiment of the present invention.

In this embodiment, the fusion memory device is a storage device including a main memory, an auxiliary memory, a memory controller, a non-memory, and logic integrated on a single chip. The logic can be a pure logic, CPU, MPU, or a combination thereof. The memory controller includes a codec for coding and decoding the multimedia. The codec is implemented in the form of a logic circuit.

The fusion memory may be implemented with a combination of various types of memories. OneNAND memory is a well-known fusion memory commercialized by Samsung Electronics Co. Ltd. The OneNAND memory is implemented by integrating a high density NAND flash cell and a high speed Static Random Access Memory (SRAM) together with a logic circuit on a signal chip. The OneNAND memory has advantages of a large storage area, high-speed data read/write capabilities of the NAND flash memory, and byte access capabilities of the NOR flash memory. That is, the OneNAND memory has a sustained read and write speed faster than the NAND and NOR memories while maintaining a capacity data storage. With these advantages and more, the OneNAND memory is expected to be used in a growing number of applications including mobile handsets, computers, digital cameras, and digital broadcast receivers.

In the following embodiments, the fusion memory device is assumed as the OneNAND device in which a memory controller 110 is provided with a codec 115 for efficiently managing the memory. The configuration of the memory controller 110 having the codec 115 may be applied to the fusion memory devices according to the embodiments of the present invention. It is assumed that the host device equipped with the fusion memory device according to one embodiment of the present invention is a mobile terminal. The mobile terminal may be a device having communication and multimedia processing functions.

Referring to FIG. 1, a fusion memory device 100 includes a main memory 130, an auxiliary memory 120, and a memory controller 110. In the case where the fusion memory is implemented as the OneNAND memory, the main memory is a NAND flash cell array, the auxiliary memory 120 is an SRAM, and the memory controller 110 is a logic circuit having a codec 115 for performing coding/decoding functions.

The functions of the memory controller 110 may be executed by software of an external controller (e.g., a system controller of the host device) connected to the fusion memory device 100. Reference numeral 210 denotes the memory control software operating on the system controller for managing the operation of the fusion memory device 100. That is, the memory controller 110 operates under the control of the memory control software 210.

The main memory 130 is structured as a NAND flash cell array for storing multimedia data and is divided into a system data region and a user data region. The auxiliary memory 120 operates as a buffer for buffering data to be written into and read from the main memory. The memory controller 110 controls to encode the input multimedia data and stores the encoded multimedia data within the main memory. The memory controller 110 also decodes the coded multimedia data read from the main memory 130 and outputs the decoded multimedia data.

The multimedia data may be, but is not limited to, video data (e.g., still or motion picture), audio data, or text data. In the case where the fusion memory device 100 is applied to a mobile terminal, the multimedia data is processed by the codec 115 of the memory controller 110.

In the case of receiving the coded data, the codec 115 may be provided with only a decoder which is capable of supporting the coded data. For example, MP3 files and digital broadcast signals are received in the coded format, whereby no coder is required. In this case, the memory controller 110 may be provided with an MP3 decoder but not a coder since the received multimedia data is directly stored within the main memory 130 without the need for any further encoding process. In the MP3 playback mode, the MP3 file can be played after being decoded by the MP3 decoder.

In the case of receiving a raw data, the codec 115 should be provided with a coder and decoder that are capable of supporting the data. For example, the image data captured by the camera may be input without a coding process. In this case, the codec 115 should be provided with an image coder and decoder such that the image captured by the camera is coded and stored within the main memory 130 and the coded image is decoded by the decoder to be displayed, under the control with the memory controller 110.

In the case of receiving multimedia data combining two or more types of data such as video and audio data, the codec 115 should be provided with a video codec (video coder and decoder) and an audio codec (audio coder and decoder). For example, the motion picture captured by the camera is composed of video and audio data. In this case, the video and audio data captured by the camera are coded by the video and audio coders to be stored within the main memory and the coded video and audio data are decoded by the video and audio decoders to be played, under the control of the memory controller 110.

Since the multimedia data is coded and decoded by the codec 115 of the memory controller 110 embedded in the fusion memory device 100, the processing load of the system controller of the host device is reduced, thereby improving the processing speed of the system and utilization of the main memory 130.

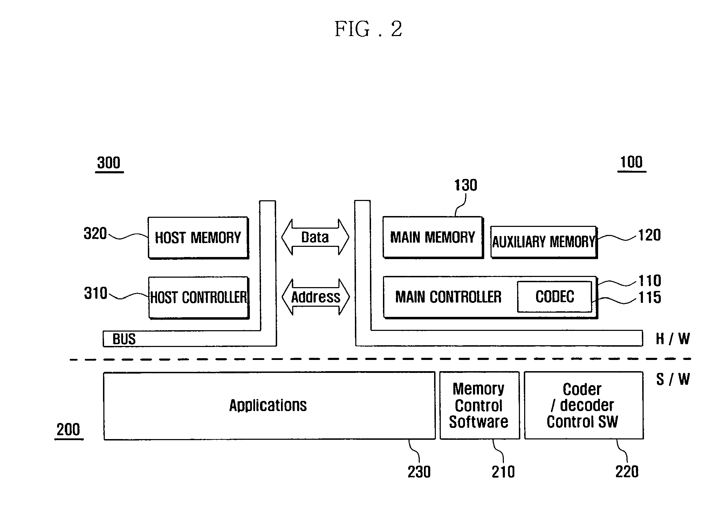

FIG. 2 is a block diagram illustrating a cooperation of a fusion memory device and a host device according to an exemplary embodiment of the present invention.

Referring to FIG. 2, a host device 300 includes a host controller 310 and a host memory 320. Here, the host device 300 is a mobile terminal. In this case, the host controller 310 becomes a terminal controller for controlling general operations of the mobile terminal, and the host memory 320 stores the multimedia data of the host device 300. The host memory 320 is provided with a working memory of the host device 300. The working memory may be an external memory (e.g., a Random Access Memory (RAM)). A software module 200 is provided with software of the host device 300 that includes applications 230, memory control software 210 for controlling the operations of the fusion memory device 100, and compression/decompression software 220 for controlling the compression/decompression of the multimedia data stored in the fusion memory device 100.

As sown in FIG. 2, the memory controller 110 of the fusion memory device 100 is provided with a codec 115 for coding input data to be stored within the main memory 130 and decoding the coded multimedia data read from the main memory 130. The host controller 310 is coupled with the fusion memory through address lines, data lines, and command lines, and the memory control software 210 controls the operations of the fusion memory 100 in cooperation with the control software, i.e. the coding/decoding control software.

In the case where a specific content is modified, the function of the application 230 is restricted, the memory controller 110 and memory control software 210 are processing the specific tasks and returns the processing result to the application 230. That is, the multimedia data can be stored after being modified in a specific format. The specific format is determined by an embedded file system.

The main memory 130 of the fusion memory device 100 can be a NAND flash memory. The multimedia data is stored within the NAND flash memory in unit of a page and is erased from the NAND flash memory in unit of a block. A page has a size of 528 bytes or more, and a block is composed of 32 pages or more. The NAND flash memory should be erased before storing the multimedia data. Accordingly, the memory controller 110 erases the address region of the main memory 130 in the unit of a block and the writes the multimedia data in the unit of a page.

The main memory 130 of the fusion memory device 100 consists of a system data region for storing programs and system information and a user data region for storing the multimedia data. The host controller 310 can access the multimedia data stored in the system data region through a NOR interface or a NAND interface. The NOR interface allows accessing the data by byte, and the NAND interface allows accessing the data by page. The fusion memory device 100 encodes the multimedia data to be stored within the main memory 130 and decodes the coded multimedia read from the main memory 130.

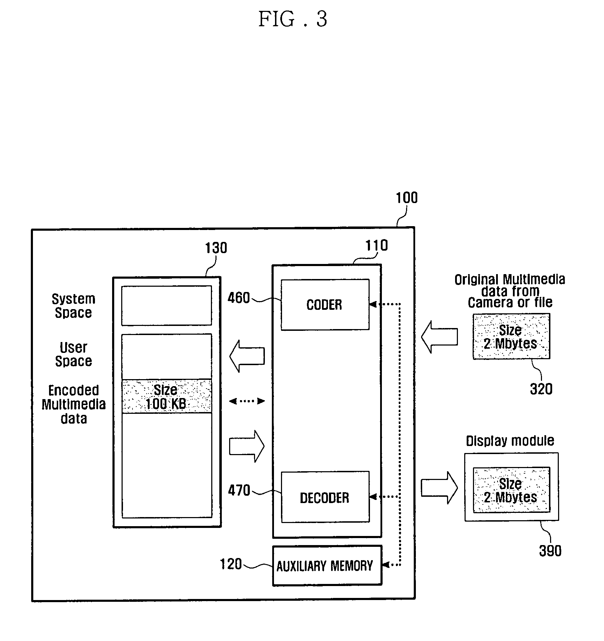

FIG. 3 is a block diagram illustrating read/write operations of a fusion memory device according to an exemplary embodiment of the present invention. The fusion memory device 100 is provided with a coder 460 and a decoder 470 composed in the form of logic circuits.

Referring to FIG. 3, the memory controller 110 controls to encode the multimedia data to be stored within the system data region of the main memory 130 and controls to decode the coded multimedia data to be read from the main memory 130. That is, the input multimedia data is compressed by the coder 460 of the memory controller 110 and then stored within the system data region of the main memory 130. Also, the coded multimedia data stored within the main memory 130 is decompressed by the decoder 470 and then read to be executed.

In the case of transferring the multimedia data (in this embodiment, still or motion picture captured by a camera) stored in the host memory 320 to the main memory 130, the memory controller 110 accesses a code (in FIG. 3, the code is 2 Mbytes in size, and the camera generates a 2-Mpixel Image) stored within the host memory 320, encodes the code read from the host memory 320, and stores the coded code within the system data region of the main memory 130.

In the case of loading the code stored in the system data region of the main memory 130, the memory controller 110 accesses the compressed code stored in the system data region of the main memory 130, decompresses the compressed code to recover the raw code by means of the decoder 470, and loads the recovered code onto the host memory 320. In FIG. 3, it is depicted that the compressed code of 10Mbytes are recovered to be 20Mbytes by the decoder 470.

The multimedia data coding process includes receiving multimedia data in a unit of data having a specific size, encoding the multimedia data using the coder, and storing the coded multimedia data within the user data region of the main memory 130. In FIG. 3, the multimedia data is coded in unit of 2 Mbytes and stored in unit of 100 Kbytes.

In the case of outputting the image stored within the user data region of the main memory 130, the memory controller 110 accesses the coded multimedia data stored within the system data region of the main memory 130 and decodes the multimedia data so as to be displayed on a screen of a display module 390 in the quality of the original image of 2 Mbytes. The display module 390 may include a speaker.

If a playback request on the multimedia data stored within the main memory is detected, the memory controller 110 controls the decoder to decode the coded multimedia data such that the decoded multimedia data is displayed on the display module. In FIG. 3, the coded multimedia data is decoded in unit of 100 Kbytes and the decoded multimedia data is displayed in unit of 2 Mbytes.

The coder 460 and decoder 470 are implemented with a coding/decoding algorithm for processing the multimedia data and are embedded in the memory controller 110 of the fusion memory device 100 in the form of a hardware module. The coder and decoder (i.e., the codec) can be configured in accordance with the types of multimedia data to be processed. For example, if the host device is a MP3 player, the memory controller 110 of the fusion memory device 100 is provided with an MP3 decoder. If the host device is a Portable Multimedia Player (PMP), the memory controller 110 is provided with at least one of a MPEG codec and H.264 codec. If the host device is a digital broadcast receiver, the memory controller 110 is provided with the H.264 codec. If the host device is a digital camera, the memory controller 110 is provided with a JPEG codec and an MPEG codec. If the Host device is a Digital Video Camcorder (DVC), the memory controller 110 is provided with an MPEG codec.

Typically, a general multimedia device supports the audio and video data including still and motion pictures. In this case, the memory controller 110 of the fusion memory device 100 is preferably provided with a plurality of codecs for processing various kinds of multimedia data. Also, a plurality of video codecs can be provided for supporting various video formats

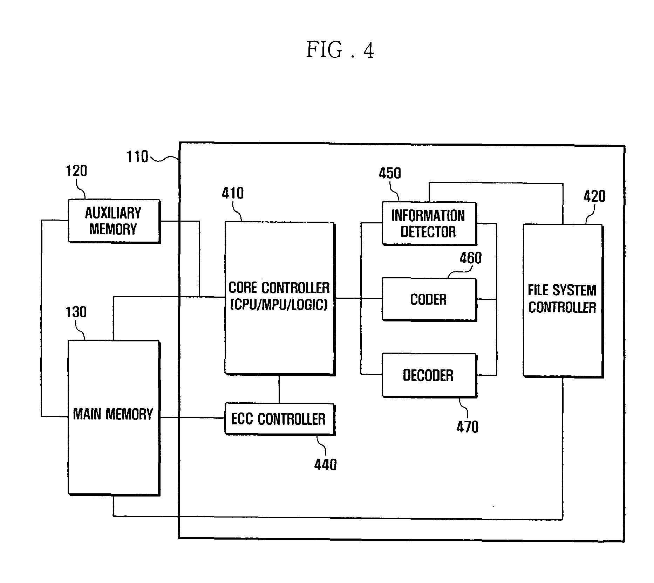

FIG. 4 is a block diagram illustrating a configuration of a fusion memory device according to an exemplary embodiment of the present invention.

Referring to FIG. 4, the fusion memory device includes a memory controller 110, an auxiliary memory 120, and a main memory 130. The main memory 130 is provided with a system data region for storing codes and a user data region for storing user data.

The memory controller 110 includes a core controller 410 for controlling the general operations of the memory controller 110, an embedded file system controller 420 for managing the user data within the user data region of the main memory 130, an Error Correction Code (ECC) controller 440 for performing the ECC, an information detector 450 for detecting information on the coding scheme, a coder 460 for encoding the multimedia data to be stored within the main memory 130, and a decoder 470 for decoding the coded multimedia data read from the main memory 130.

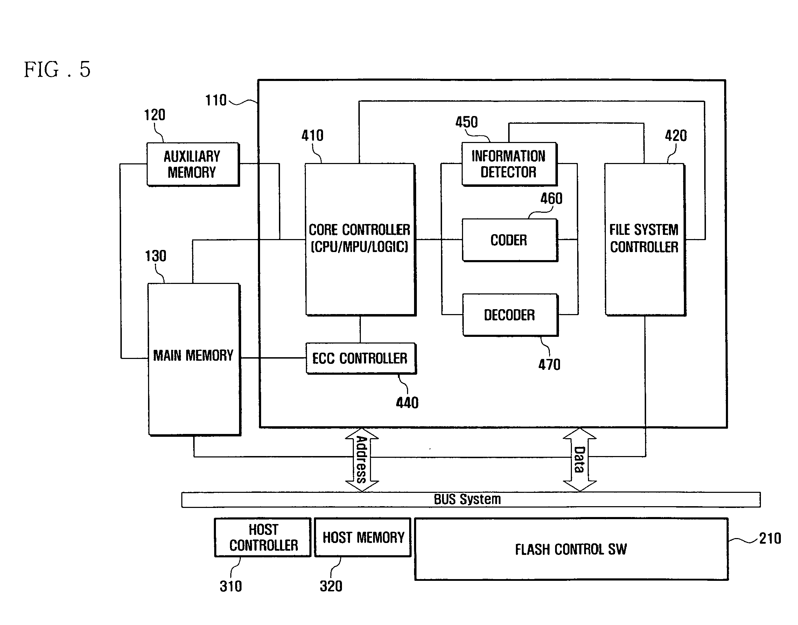

FIG. 5 is a block diagram illustrating an interoperation between the fusion memory device of FIG. 4 and a host device according to an exemplary embodiment of the present invention.

Referring to FIG. 5, the host device 300 includes a host controller (e.g. a Central Processing Unit (CPU)) 310 and a host memory (e.g. a RAM) 320. The host memory 320 is an external memory for storing the multimedia data (including the code and user data) of the host device and is the working memory of the host device. Also, the host device is provided with a host software module including memory control software 210 for controlling the operation of the fusion memory device 100. The host software module is the host controller 310 which is configured to access the fusion memory device 100.

Multimedia data storage and output operations of the fusion memory device is described in more detail with reference to FIGs. 4 and 5. The information detector 450 converts the address for access to the information of the main memory 130 and determines the coding scheme on the basis of the access control information received from the memory control software 210 module of the host controller 310. The information detector 450 is provided with a flag translator and an address converter. The flag translator translates the control information (e.g. a flag) on the input multimedia data and transfers to the memory controller 410 the coding flag appropriate for each request.

The flag can be a compression flag (e.g. "data.comp") determining the coding scheme for the multimedia data to be stored in the user data region (e.g. user space or file system area) of the main memory 130. The address converter converts the address received from the host controller 310 into an address of the corresponding area of the main memory 130. In the case of code access mode, the address converter outputs a signal corresponding to the data command (CMD) to the file system controller 420. The data command (CMD) is a read/write command. The file system controller 420 transfers the information of the actual position of the file to the core controller 410.

The core controller 410 determines the coding/decoding scheme of the accessed multimedia data accessed on the basis of the output of the information detector 450 and the position of the multimedia data to be accessed in the main memory 130 on the basis of the output of the file system controller 420. The core controller 410 controls such that the multimedia data is coded according to the coding scheme and the coded multimedia data is written within the user data region of the main memory 130 according to the converted address information. In the multimedia data read mode, the core controller 410 accesses the coded multimedia data stored within the user data region of the main memory 130 with reference to the converted address information and controls the decoder 470 to decode the coded multimedia data read from the corresponding area according to the coding scheme.

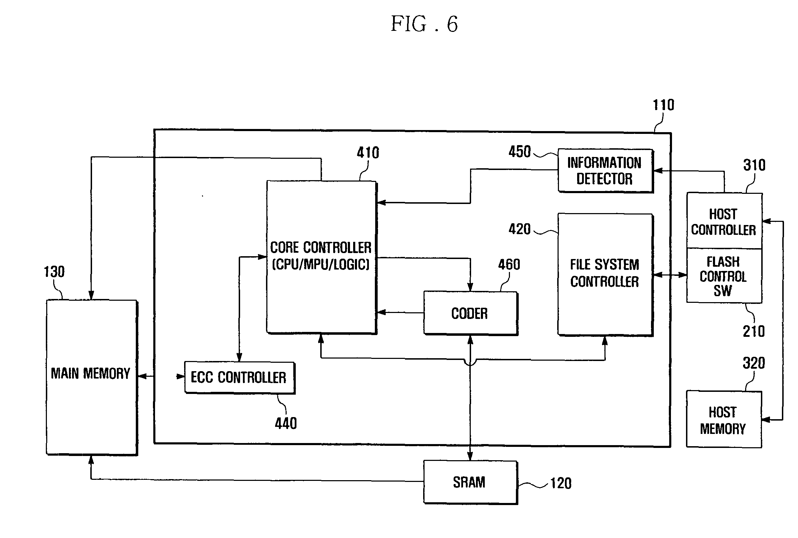

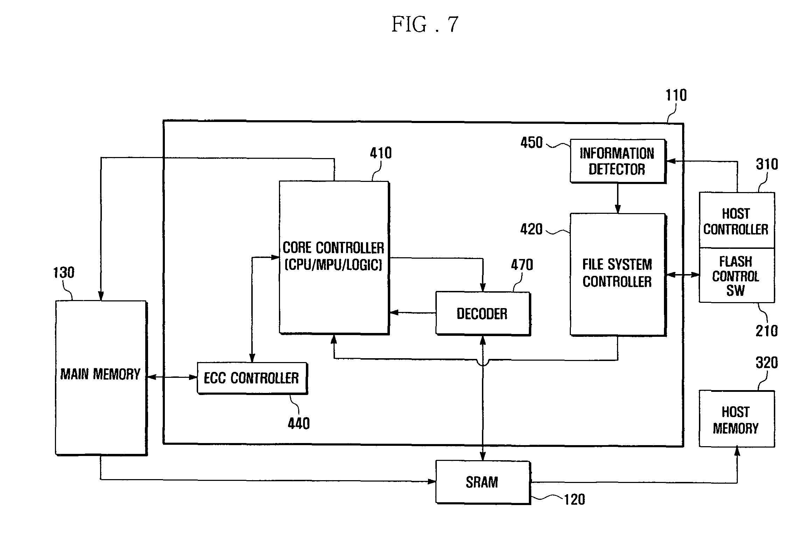

FIG. 6 is a block diagram illustrating how to encode and store multimedia data in the fusion memory device of FIG. 4, and FIG. 7 is a block diagram illustrating how to decode and output multimedia data from the fusion memory device of FIG. 4.

In the case of storing the multimedia data within the user data region of the main memory 130, the host controller 310 receives the multimedia data to be stored from the host memory 320. The multimedia data may be, for example, but not limited to, a video stream, a raw camera image stream, or an audio stream. The host controller 310 transfers the multimedia data to the information detector 450.

The information detector 450 analyzes the multimedia data to obtain a coding/decoding scheme and transfers control information indicating the coding/decoding scheme for the multimedia data to the core controller 410. The core controller 410 checks the control information (e.g., header information) of the multimedia data received from the information detector 450 and activates an appropriate coder and decoder on the basis of the control information. In the write mode, the core controller 410 activates the coder 460. The core controller 410 transfers the multimedia data to be buffered in the auxiliary memory 120, and the coder 460 encodes the multimedia data by a predetermined size, the encoded multimedia data also being buffered in the auxiliary memory 120. The core controller 410 waits for the file system information. The file system controller 420 checks and transfers the file system information to the core controller 410. If the file system information is received, the core controller 410 outputs a write command to the main memory such that the coded multimedia data in the buffer is stored at a corresponding location of the main memory. The main memory 130 stores the coded multimedia data output from the auxiliary memory 120 in a predetermined location of the user data region. After the multimedia data is stored in the main memory 130, the ECC controller 440 checks for errors in the multimedia data and, if normal, transfers the multimedia data to the core controller 410. The core controller 410 outputs storage completion information to the file system controller 420.

As repeating the above operations, the memory controller 110 of the fusion memory device 100 encodes the multimedia data input by the host device 300 and writes the encoded multimedia data in the user data region of the main memory 130.

Referring to FIG. 7, if control information for reading the multimedia data stored in the user data region of the main memory is received from the host controller 310, the information detector 450 extracts information on the location (e.g., memory address) of multimedia data in the main memory 130 and coding flag from the control information and transfers the memory address and coding flag to the file control system 420. The file system controller 420 transfers the memory address and coding flag to the core controller 410. The core controller 410 maps the memory address to a location of the user data region at which the multimedia data is stored to determined the location in the main memory 130 and generates a read command for reading the multimedia data. At this time, the ECC controller 440 reads the ECC from the main memory 130 and generates ECC information. If the ECC information is normal, the ECC information is transferred to the core controller 410. The core controller 410 controls to configure the decoder 470 with the decoding scheme for decoding the coded multimedia data, and the auxiliary memory 120 buffers the coded multimedia data read from the user data region of the main memory 130 under the control of the core controller 410. Next, the decoder 470 decodes the multimedia data output from the auxiliary memory 120 and informs the core controller 410 that the decoding is complete. Finally, the file system controller 420 controls, under the control of the core controller 410, such that the multimedia data is stored in the host memory 320.

As described above, the fusion memory device of the present invention is provided with at least one embedded codec (a pair of a coder and a decoder) for encoding and decoding multimedia data so as to process encoding and decoding procedures by itself, thereby reducing processing load of a host device. Also, the fusion memory device of the present invention is provided with an auxiliary memory which is used for buffering data during the coding and decoding process, thereby reducing the use of external memory, resulting in improvement of memory utilization efficiency.

Although exemplary embodiments of the present invention have been described in detail hereinabove, it should be clearly understood that many variations and/or modifications of the basic inventive concepts herein taught which may appear to those skilled in the present art will still fall within the spirit and scope of the present invention, as defined in the appended claims.

## Claims

1. A fusion memory device, comprising:
a main memory for storing multimedia data;
an auxiliary memory for buffering the multimedia data in a write mode and a read mode; and
a memory controller which controls buffering the multimedia data in the auxiliary memory, encoding the buffered multimedia data, and writing the encoded data in the main memory in the write mode, and controls decoding the multimedia data output from the main memory, buffering the decoded multimedia data, and outputting the buffered multimedia data to a host device.

2. The fusion memory device of claim 1, wherein the memory controller comprises:
at least one coder for encoding the multimedia data buffered in the auxiliary memory in the write mode;
at least one decoder for decoding the multimedia data buffered in the auxiliary memory in the read mode;
an information detector for detecting codec information and file address information from the multimedia data;
a file system controller for generating file system allocation information for accessing the multimedia data on the basis of the file address information; and
a core controller for storing the coded multimedia data in the main memory in the write mode and decoding and outputting the multimedia data in the read mode, on the basis of the information output by the information detector and the file system controller.

3. The fusion memory device of claim 2, wherein the core controller controls activating the at least one coder to encode the multimedia data on the basis of the codec information and configuring the main memory in which the multimedia data encoded by the coder is stored at a location set by the file system controller in the write mode, and controls configuring the main memory from which the multimedia data is read and activating the at least one decoder to decode the multimedia data and output the decoded multimedia data in the reading mode.

4. The fusion memory device of claim 3, wherein the core controller controls buffering the multimedia data input from the host device in the auxiliary memory, encoding the buffered multimedia data using the coder, buffering the coded multimedia data in the auxiliary memory, and storing the coded multimedia data in the main memory, in the write mode, and controls reading the multimedia data from the main memory, decoding the read multimedia data, buffering the decoded multimedia data in the auxiliary memory, and outputting the decoded multimedia data to the host device in the read mode.

5. The fusion memory device of claim 4, wherein the coder and decoder are a video coder and a video decoder implemented in the memory controller in the forms of hardware components.

6. The fusion memory device of claim 4, wherein the coder and decoder are an audio coder and an audio decoder implemented in the memory controller in the forms of hardware components.

7. The fusion memory device of claim 4, wherein the coder and decoder comprises a pair of a video coder and a decoder and a pair of an audio coder and a decoder implemented in the memory controller in the forms of hardware components.

8. A data access method for a fusion memory device having a main memory, auxiliary memory, and at least one pair of coder and decoder, comprising:
analyzing multimedia data input by a host device in a write mode;
activating a coder on the basis of the analysis result;
encoding the multimedia data using the coder;
storing the coded multimedia data in the main memory;
activating a decoder in a read mode;
decoding the multimedia data using the decoder; and
outputting the decoded multimedia data to the host device.

9. The data access method of claim 1, further comprising:
buffering the multimedia data input by the host device in the auxiliary memory;
encoding the buffered multimedia data; and
writing the coded multimedia data in the main memory.

10. The data access method of claim 9, further comprising:
extracting allocation information of a file system from the multimedia data; and
setting a location for storing the multimedia data in the main memory on the basis of the allocation information.

11. The data access method of claim 8, further comprising:
reading the coded multimedia data from the main memory;
buffering the read multimedia data in the auxiliary memory;
informing the host device of the buffered multimedia data; and
outputting the buffered multimedia data to the host device.
